# EUROPEAN PATENT SPECIFICATION

(11) **EP 3 628 756 B1**
(45) Date of publication and mention of the grant of the patent: **06.03.2024**
(21) Application number: 17911052.3
(22) Date of filing: 27.11.2017
(51) Int. Cl.: C23C 16/458, C23C 16/44, C23C 16/505, C23C 16/511, C23C 16/515, B05D 1/00, B05D 5/08, B82Y 40/00, H01J 37/32

(54) **SUBSTRATE-MOVING TYPE APPARATUS AND METHOD FOR PREPARING NANO COATING BY MEANS OF PLASMA DISCHARGE**
SUBSTRATBEWEGUNGSVORRICHTUNG UND VERFAHREN ZUR ZUBEREITUNG EINER NANOBESCHICHTUNG MITTELS PLASMAENTLADUNG
APPAREIL DE TYPE À DÉPLACEMENT DE SUBSTRAT ET PROCÉDÉ DE PRÉPARATION DE NANO-REVÊTEMENT AU MOYEN D'UNE DÉCHARGE DE PLASMA

(30) Priority: 21.05.2017 CN 201710360380
(43) Date of publication of application: 01.04.2020
(73) Proprietor: Jiangsu Favored Nanotechnology Co., Ltd., Donghuan Rd., Yuqi Industrial Park Wuxi Jiangsu 214183 (CN)
(72) Inventor: ZONG, Jian, Wuxi, Jiangsu 214183 (CN)
(74) Representative: Yalçiner Patent and Consulting Ltd.
(86) International application number: PCT/CN2017/113194
(87) International publication number: WO 2018/214452

(56) References cited:
- CN-A- 105 705 590
- CN-A- 106 622 824
- CN-A- 106 622 824
- CN-A- 106 637 140
- CN-A- 106 958 012
- CN-U- 204 803 400
- CN-U- 204 874 717
- CN-U- 206 219 660
- US-A1- 2009 318 609
- US-A1- 2014 342 103
- LI et al: "Antifouling performance for polyvinylidene fluoride membrane modified by plasma treatment in a MBR", Membrane Science and Technology, vol. 34, no. 3, 1 June 2014 (2014-06-01), pages 110-115, XP055662347, ISSN: 1007-8924, DOI: 10.16159/j.cnki.issn1007-8924.2014.03.015

## Description

### TECHNICAL FIELD

The present invention belongs to the technical field of plasma chemical vapor deposition, and more particularly, the present invention relates to an apparatus and a method for preparing a nano coating.

### BACKGROUND

Corrosive environment is the most common factor for damages to electronic devices. Environmental corrosion gives rise to the corrosion of solid materials, degradation of insulation performance of conductors/semiconductors, and failure phenomena, such as short circuit, open circuit or poor contact, in electronic devices. At present, among products in high-tech industries such as national defense and aerospace, electronic parts account for an increasingly great share, and the requirements on properties of electronic products, such as moisture resistance, mould resistance and corrosion resistance, are becoming increasingly strict. While in the field of communications, the requirements on heat dissipation of communication devices and stability and reliability of signal transmission have become higher and higher along with the continuous technical progress and continuous increase of communication frequencies. Thus, a reliable method is needed for providing effective protection for circuit boards and electronic elements, while not affecting normal heat dissipation and signal transmission.

Characterized by economic efficiency, easy application and a wide range of applications, polymer coating is usually used for protection of material surfaces, and it can provide good physical and chemical durability for various materials; based on the barrier property of polymer coating, a protective film formed on the surface of electronic products and circuit boards can effectively isolate circuit boards and protect circuits from corrosion and damages in a corrosive environment, thereby improving the reliability of electronic devices, enhancing their safety factors and ensuring their service lives. As such, polymer coating is used as an anticorrosive coating.

Conformal coating is a technological process during which a specific material is applied on PCB to form an insulation protective layer that is of the same shape as that of the coated object. As a common waterproof method for circuit boards, conformal coating can effectively isolate circuit boards and protect circuits from corrosion and damages under adverse environments. There are also some problems and drawbacks with current preparation processes of conformal coating: solvents in the liquid phase method tend to cause damages to circuit board devices; the high temperature for heat curing of coatings tend to cause damages to devices; it is hard for photo-cured coating to reach the interior of closed devices. Union Carbide Co. in the U.S.A. developed and applied a new conformal coating material. Parylene coating is a polymer of p-xylene. Featured by low moisture and gas permeability and high barrier effect, it is moisture proof, water proof, rust proof, and acid and alkali resistant. It has been found through research that poly-p-xylylene is produced through deposition in a vacuum state and it can be applied in the fields where liquid coating cannot be involved, such as the protection of high frequency circuits and extremely weak current systems. The thickness of a polymer film coating is the main reason that causes the protection by a conformal coating formed by vapor deposition of poly-p-xylylene to fail, and in the case that the thickness of a polymer film coating on a printed circuit board assembly is within a range of 3-7 micrometers, localized rust tends to occur and the coating fails to provide protection. The thickness of coating should be equal to or greater than 30 micrometers, provided that high frequency dielectric loss is not affected. Parylene coating has relatively high requirements for the pretreatment of printed circuit boards to be protected. For conducting assemblies, signal transmission assemblies, and radio frequency assemblies, masking pretreatment needs to be performed on circuit board assemblies at the time of vapor disposition to form a conformal coating so as to avoid impacts on properties of the assemblies. This disadvantage greatly restricts the application of Parylene coating. It is hard to widely apply Parylene coating because of costly raw materials for preparation thereof, strict conditions for the coating preparation (requirements of high temperature and high vacuum degree) and low film forming speed. In addition, a thick coating tends to give rise to issues like poor heat dissipation, signal blocking, more coating defects.

Plasma chemical vapor deposition (PCVD) is a technology that uses plasma to activate reaction gases, to facilitate chemical reactions on a substrate surface or in a space near a surface, and to generate solid films. Coatings formed with PCVD have the following advantages:
(1) It is a dry process, and films formed are even without pinholes.
(2) Plasma polymer films have stable chemical and physical properties, such as solvent resistance, chemical resistance, heat resistance and wear resistance.
(3) Plasma polymer films can be well bonded to a substrate.
(4) A uniform thin film can also be formed on an extremely uneven and irregular substrate surface.
(5) The temperature for coating preparation is low, which can be carried out at normal temperature, thereby effectively avoiding damages to temperature sensitive devices.
(6) The plasma technology not only can be used for the preparation of coating with a micrometer-level thickness, but also can be used for the preparation of ultrathin nano coating.

By use of the chemical vapor deposition technology, P2i Company in the U.K. developed a polymer nano coating by using a method based on a specific low duty ratio pulse discharge. However, the preparation process of the method based on the specific low duty ratio pulse discharge cannot realize an effective combination and control between the energy provided and bond lengths and bond energies of different groups in raw chemical materials or molecular weights of the materials. Moreover, the scratch resistance and durability of the prepared coating are not ideal. Limited by the properties of this coating, only a lyophobic nano-coating can be formed on electronic and electrical devices at present, which cannot effectively provide resistance to a corrosive environment. Furthermore, the compact protective coating prepared with the method based on a specific low duty ratio pulse discharge has fatal defects: from a microscopic angle, a low power density during a coating process is not conductive to the formation of compact structures, and may even be unable to form stable film structures; from a macroscopic angle, a low power density is not conductive to the high speed growth of coating, and the efficiency is low in actual production, which limits its application.

In existing preparation processes of plasma chemical vapor deposition coating, substrates are always fixed, and there is no relation between the movement state of a substrate and the plasma discharge energy; a continuous discharge method is used to process the static substrate in a chamber, and under the action of continuous discharge, activated broken chains in monomers usually combine into a film through simple piling. The obtained coating usually has a loose structure and high pulverization degree, which is not conductive to the formation of micro compact structure of the coating. Thus, the coating has poor protective properties, such as water resistance, moisture resistance, corrosion resistance and solvent resistance.

Since the plasma and raw chemical materials have different densities in different regions of a reaction chamber, and the substrate remains motionless, the coating deposition velocity is slow in some areas, which leads to a low production efficiency. Moreover, there is a phenomenon that uniformity and compactness are significantly different.

Documents considered to be relevant may include CN 106622824 A (WUXI RJ IND CO LTD) 10 May 2017; and US 2018/174803 A1, which disclose a plasma polymerization apparatus. The apparatus includes a reaction chamber in a shape substantially symmetrical to a central axis, a rotation rack in the chamber to rotate relative to the chamber about the central axis and a collecting tube positioned along the central axis of the chamber. Plasma discharge mechanisms positioned around the perimeter of the chamber disperse reactive species from the outer perimeter of the reaction chamber toward the central axis of the reaction chamber.

US 2009/318609 A1 (BADYAL JAS PAL SINGH [GB] ET AL) 24 December 2009 discloses a method for applying a coating containing reactive nitrogen functionality contained within an aromatic heterocyclic structure to a substrate. The method includes subjecting the substrate to a plasma discharge of a monomer possessing the heterocyclic nitrogen functionality. The method employs a chamber fitted with a two-stage rotary pump connected to a liquid nitrogen cold trap.

US 2014/342103 A1 (PETERSON JULIEN [FR] ET AL) 20 November 2014 discloses a method for producing a superamphiphobic coating on a substrate comprising the steps of a) providing a substrate, b) generating a plasma in a treatment space, under atmospheric pressure, using a dielectric barrier discharge, by supplying a plasma gas (6) between at least a first and a second electrode (2 and 3) connected to alternating current (AC) power means (7), said electrodes (2 and 3) defining said treatment space (5), c) introducing into said plasma a coating a monomer material. The method employs application of successive passes over the substrate and discloses moving the electrodes or the substrate translationally.

### SUMMARY

In order to solve the technical issues mentioned above, the present invention provides an apparatus and a method for preparing a nano coating through plasma discharge with a moving substrate. In the coating preparation process, the substrate performs a planar or three-dimensional space reciprocating motion, planar reciprocating motion, circular motion, elliptic motion, spherical motion, planetary motion or a motion of another irregular route relative to a reaction chamber and an electrode.

Meanwhile, continuous discharge, high duty ratio pulse discharge or periodically alternating power discharge of plasmas at a corresponding power is carried out. Additional cross-linking points are introduced to form a cross-linked structure by introducing other monomer components with a poly-functional cross-linked structure through the plasma energy. Plasmas are generated through the plasma discharge, and through the control over the relationship between the plasma discharge energy and the bond energy of monomers, low temperature plasmas can effectively activate active groups with high energy in the monomer components so as to obtain active sites; and in the meanwhile, the introduced additional active sites are cross-linked and polymerized with each other in the plasma environment to form a compact mesh structure.

The technical solution that the present invention adopts is as follows:

A method for preparing a nano coating through plasma discharge with a moving substrate by using the above apparatus, characterized in that it consists of the following steps:
(1) Put a substrate into the reaction chamber of the nano coating preparation apparatus according to claim 1, vacuum the reaction chamber continuously until the vacuum degree in the reaction chamber is in a range of 10-200millitorr, then send in an inert gas (He or Ar), and turn on the movement mechanism so that the substrate can move in the reaction chamber;
(2) Send a monomer vapor into the reaction chamber till the vacuum degree reaches 30-300millitorr, enable the plasma discharge, and carry out chemical vapor deposition. The deposition process consists of pretreatment and coating phases. In the pretreatment phase, the plasma discharge power is 120-400 W, and the continuous discharge time is 60-900 s; subsequently in the coating phase, the plasma discharge power is adjusted to 10-75 W, the continuous discharge time is 600s-7200 s, and a multi-functional nano coating is prepared through chemical vapor deposition on the substrate surface;
(3) stopping supplying the monomer vapor, and in the meanwhile,stopping the plasma discharge, vacuumizing continuously, sending in the air to one barometric pressure after keeping the vacuum degree of the reaction chamber in a range of 10-200 millitorr for 1-5 min. , stopping a movement of the substrate , and taking out the substrate.

The components of the monomer vapor are:
a mixture of at least one mono-functional unsaturated fluorocarbon resin and at least one poly-functional unsaturated hydrocarbon derivative, wherein the mass fraction of the poly-functional unsaturated hydrocarbon derivative in the monomer vapor is 15-65 %;
the mono-functional unsaturated fluorocarbon resin consists of:
   3-(perfluoro-5-methyl hexyl)-2-hydroxypropyl methacrylate, 2-(perfluorodecyl) ethyl methacrylate, 2-(perfluorohexyl) ethyl methacrylate, 2-(perfluorododecyl) ethyl acrylate, 2-perfluoro octyl ethyl acrylate, 1H, 1H, 2H, 2H-perfluoro octanol acrylate, 2-(perfluorobutyl) ethyl acrylate, (2H-perfluoro propyl)-2-acrylate, (perfluoro cyclohexyl) methyl acrylate, 3, 3, 3-trifluoro-1-propyne, 1-ethinyl-3, 5-difluorobenzene or 4-ethinyl trifluorotoluene;
the poly-functional unsaturated hydrocarbon derivative consists of:
   ethoxylated trimethylolpropane triacrylate, tripropylene glycol diacrylate, poly (ethylene glycol) diacrylate, 1, 6-hexanediol diacrylate, diacrylicgylcol ester, diethylene glycol divinyl ether, or neopentyl glycol diacrylate.(3) Stop the supply of the monomer vapor, and in the meanwhile, stop the plasma discharge, vacuum continuously so as to keep the vacuum degree of the reaction chamber in a range of 10-200 millitorr for 1-5 min, then send in the air to one barometric pressure, stop the movement of the substrate, and take out the substrate.

The substrate in Step (1) is a solid material, and the solid material can be electronic products, electrical components, assembled electronic semi-finished products, PCB boards, metal plates, Teflon plates or electronic parts and components, and when the substrate surface is provided with the multi-functional nano coating, any of the surfaces can be exposed to an environment of water, fungi, acidic or alkaline solvents, acidic or alkaline salt spray, acidic atmosphere, organic solvent immersion, cosmetics, perspiration, thermal cycling impact or alternating dampness and heat.

In the Step (1), the temperature of the reaction chamber is controlled within a range of 30-60°C, and the incoming flow of the inert gas is 5-300sccm.

In the Step (2), the introduction of a monomer vapor is to atomize and volatilize the monomer through a feeding pump, and introduce the monomer to the reaction chamber by a low pressure of 10-200millitorr, and the incoming flow of the monomer is 10-1000 µL/min.

The purpose of the pretreatment phase is to activate the substrate surface and form lots of active sites on the substrate surface. This bombardment pretreatment not only can remove impurities from the substrate surface, but also can activate the substrate surface, thus it is conductive to the coating deposition and improving the binding force between the coating and the substrate.

In the pretreatment phase, the plasma discharge mode is high power (120-400 W) continuous discharge, while in the coating phase, the plasma discharge mode is low power continuous discharge with the power being 10-75 W. The plasmas generated during the continuous plasma discharge and deposition have an etching effect on the deposition film; in the coating phase, the low power continuous discharge combined with the kinetic characteristics of the substrate is conductive to speeding up the chemical deposition, and compared with the existing low duty ratio pulse discharge technology, the continuous discharge mode can form thicker and more compact films within a certain period of time, and the coating efficiency is higher. Thus, it can solve the fatal weakness of the compact protective coating prepared by P2i Company in the U.K. with the method based on a specific low duty ratio pulse discharge.

Under the low vacuum plasma discharge environment, chemical bonds of the monomers with an active molecular structure are broken via the effective output of energy, free radicals of high activity are formed, and then the free radicals in the excited state and the activated groups on surfaces of mobile phones and other products initiate polymerization by means of chemical bond combination to form a nano waterproof membrane and form a multi-functional nano coating on the substrate surface.

The substrate in Step (1) is a solid material, and the solid material can be electronic products, electrical components, assembled electronic semi-finished products, PCB boards, metal plates, Teflon plates or electronic parts and components, and when the substrate surface is provided with the multi-functional nano coating, any of the surfaces can be exposed to an environment of water, fungi, acidic or alkaline solvents, acidic or alkaline salt spray, acidic atmosphere, organic solvent immersion, cosmetics, perspiration, thermal cycling impact or alternating dampness and heat.

In the Step (1), the temperature of the reaction chamber is controlled within a range of 30-60°C, and the incoming flow of the inert gas is 5-300sccm.

In the Step (2), the plasma discharge mode is radio frequency discharge, microwave discharge, intermediate frequency discharge, high frequency discharge or spark discharge, and the waveforms of high frequency discharge and intermediate frequency discharge are sinusoidal or bipolar pulses. The radio frequency plasmas are plasmas generated from the discharge of high frequency electromagnetic field. The microwave method is to use microwave energy to activate plasmas and has an advantage of high energy utilization efficiency; and in the meanwhile, plasmas are pure due to electrodeless discharge, at present, it is an excellent method for high quality, high speed and large area preparation.

During the preparation of coating, the kinetic characteristics of the substrate interact with the plasma discharge energy, and the issues of uneven and uncompact coating deposition are solved by combined configuration of motion parameters and plasma discharge energy. During the preparation process, the substrate moves at the time of plasma discharging, which increase the coating deposition efficiency, and also improve the uniformity and compactness of the coating thickness.

The prepared coating is characterized by the properties of resistance to water, moisture, fungus, acid and alkaline solvents, acid and alkaline salt sprays, acidic atmosphere, organic solvent immersion, cosmetics, perspiration, thermal cycling impact (-40 °C-+75 °C) and alternating dampness and heat (humidity: 75%-95%). At the time of having the above protective properties, the influence of the coating on radio frequency communication signals within the range of 10 M-8 G is lower than 5 % When the coating thickness is 1-1000 nm.

The above technical solution of the present invention has the following advantages relative to the prior art:
1. Continuous low power discharge is introduced into the coating phase, and during the continuous discharge, two processes including polymerization and etching will occur at the same time. On one hand, the end of a molecular chain in an excited state broken by plasmas bonds with an active site on the substrate surface by means of a chemical bond; on the other hand, plasmas will etch molecular chains of low chemical bond energy on the surface after polymerization and play the role of activation, and the alternating action of the two processes makes the polymerized nano coating more compact.
2. During the pretreatment and coating phases, the substrate moves in the reaction chamber, making the coating thicknesses at different positions of the substrate tend to be consistent and solving the issue of uneven coating thickness on the substrate surface caused by different monomer densities in different areas of the reaction chamber.
3. During the preparation process, the kinetic characteristics of substrate interact with the plasma discharge energy. The substrate moves at the time of outputting plasma discharge energy, which increases the deposition efficiency and greatly improves the compactness of the obtained multi-functional nano protective coating. Since the deposition efficiency is improved, the applied amount of chemical monomer raw materials in the monomer vapor is only 10%-15% of the applied amount according to the prior art, thereby reducing the emission of exhaust and waste gases and being more environmental friendly. The present invention is of great significance in the improvement of actual production efficiency.
4. The introduction of poly-functional cross linked structures in monomer materials promotes, in terms of microstructure, the formation of a compact mesh structure of the coating, and improves the acid/alkali corrosion resistance of the coating in various environments while ensuring hydrophobicity.

Mono-functional monomers are selected for general plasmas polymerization so as to obtain a coating of a cross-linked structure. The cross-linked structure is formed by the cross-linking of lots of active sites which are generated from the broken chains in monomers at the time of plasma discharging. However, such cross-linked structures are relatively loose and have many linear components, thus their solution permeability resistance and dissolubility are poor. Through the introduction of other monomer components of poly-functional cross-linked structures, the present invention brings in additional cross-linking points so as to form cross-linked structures. At the time of plasma discharging, the active groups with high energy in monomer components will be broken through the effective control and output of energy and under the action of low temperature plasmas, so as to form active sites. The introduced additional active sites carry out cross-linking and polymerization with each other in the plasma environment, thereby forming compact mesh structures.

Compared with coating structures of many loose linear components, the mesh structure has better compactness and can effectively improve the corrosion resistance of a film. In a plasma environment, the surface of the coated substrate is activated to obtain numerous active sites, and such active sites will, through strong chemical bonds, be bonded with the active free radicals of a monomer material activated by plasmas, leading to elementary reactions of various forms and types such that the nano film of the substrate material has an excellent binding force and mechanical strength. Effective control and adjustment of corrosion resistance on the material surface can be realized by controlling combinations of different monomers and different process conditions, and the structure which has a special microstructure, a compact base layer and a rough surface layer can be obtained. Its comprehensive property of environmental corrosion resistance is improved by 20%-35%.

5. The polymer nano coating of a composite and gradually changed structure is obtained by introducing other monomer components with cross-linked structures, controlling the monomer ratio, providing the equipment corresponding energy outputs and effective changes of process parameters according to differences in molecular bond energies, bond lengths and vaporization temperatures of different monomers, which not only ensures the hydrophobicity of the film, but also improves the resistance of electronic products and other products against corrosive environment.

In daily life, electronic devices are liable to be damaged because of the corrosion caused by corrosive environment. Since they are used mostly in a corrosive environment, irreversible damages will occur to the electronic devices after a long period. The coating method according to the present invention makes nano technologies much more useful in improving the actual production efficiency. Thanks to the service life of the coating in a corrosive environment, the protective effects on products have been improved. It is mainly applied to the products as follows:
(1) Portable equipment keyboards: portable keyboards are small and light, and are often used on computers, mobile phones and other devices. They can facilitate users to work during trips. However, when they are contaminated by common liquids, such as water from accidently tipped cups and soaking by rain water or sweat, the inside of a keyboard can be easily short circuited and broken down. When this nano coating is applied to a keyboard, it can ensure that the keyboard surface is easy for cleaning, the keyboard remains intact when exposed to water, and the keyboard can adapt to more severe environments.
(2) LED display screens: LED display screens are used for commodity advertisement, store decoration, illumination, warning and other purposes. For some purposes, LED display screens may be exposed to rain water, heavy dust or other severe environments. For example, when it rains, for outdoor LED display screens of shopping malls, warning lights on roads and LED display control panels in workshops tend to fail due to such severe environments. Moreover, dust can easily accumulate on LED display screens and is not easy to be cleaned; however, after the nano coating is adopted, the issues can be solved effectively.
(3) Intelligent fingerprint lock: fingerprint lock is an intelligent lock. It combines computer information technologies, electronic technologies, mechanical technologies and modern hardware technologies, and is widely applied to police criminal investigation and judicial fields. However, when exposed to water, its internal circuit tends to be short circuited. It is so hard to repair that such a lock must be violently removed. After this coating is applied, this issue can be avoided.
(4) Hearing aid and Bluetooth earphone: neither a hearing aid nor a Bluetooth earphone has communication lines. After adopting this coating, users can use such devices in a water environment, such as showers and rainy days, within a certain time, and such devices will not be damaged by immersed in rain water.
(5) Some sensors: some sensors need to be used in a liquid environment, such as water pressure and oil pressure sensors, sensors used in underwater equipment, and sensors usually exposed to water in work environment. After such sensors are provided with the coating, they will not be broken down by invasion of a liquid into the internal structures of mechanical devices.
(6) The majority of 3C products: such as mobile phones, notebook computers, PSP, and so on.
(7) Other devices that should be waterproof: including devices that operate in a wet environment, or may encounter unforeseen circumstances, such as spills by common liquids, which will affect the normal operation of their internal weak current circuits.

The multi-functional nano coating prepared with this method can also be applied to the following different environments and related products:

Water resistance, moisture resistance and fungus resistance:
1. Interior decoration of houses: ceiling, wallpaper, ceiling lamp, window curtain and screening in a bathroom. 2. Articles of daily use: mosquito net, table lamp cover, chopstick holder, and automobile rearview mirror. 3. Cultural relics and works of art: copybook for calligraphy, antique, wood carving, leather, bronze ware, silk, ancient costume and ancient book. 4. Electronic components and electronic products: sensors (working in humid or dusty environments), chips of various electronic products (electronic sphygmomanometers and intelligent watches), circuit boards, mobile phones, LED display screens, and hearing aids. 5. Precision instruments and optical devices: mechanical watches and microscopes.

Resistance to acidic and alkaline solvents, resistance to acidic and alkaline salt sprays, and resistance to acidic atmosphere:
1. Interior trim parts of houses: wallpaper and ceramic tiles.
2. Protective appliance: Acid (alkali) proof gloves and acid (alkali) proof protective clothing. 3. Mechanical equipment and pipelines: flue gas desulfurization equipment, sealing elements (acid / alkaline lubricating oil), pipelines, valves, and lining of large diameter marine conveying pipelines. 4. Various reaction kettles and reactors. 5. Production and storage of chemicals, sewage treatment and aeration tanks. 6. Others: acid and alkali workshops, anti-alkali aerospace, energy and power, ferrous metallurgy, petro-chemical, medical treatment and other industries, storage containers, statues (to mitigate corrosion by acid rain), and sensors (in acidic / alkaline environments).

Resistance to organic solvent immersion, cosmetic resistance, and perspiration resistance:
1. Alkane, alkene, alcohol, aldehyde, amine, ester, ether, ketone, aromatic hydrocarbon, hydrogenated hydrocarbon, terpene hydrocarbon, halohydrocarbon, heterocyclic compound, nitrogen containing compound and sulfocompound solvents; 2. Cosmetic packaging containers; 3. Fingerprint locks and earphones.

Resistance to thermal cycling impact (-40 °C-+75 °C), resistance to alternating dampness and heat (humidity: 75%-95%): electrical engineering, electronic and automotive electrical appliances, such as devices in fields of aerospace, auto, home appliances and scientific research.

### BRIEF DESCRIPTION OF THE DRAWINGS

Figure 1 is a front structural view of an apparatus for preparing a nano coating through plasma discharge with a substrate in circling motion (not part of the present invention).
Figure 2 is a top view of Figure 1 (not part of the present invention).
Figure 3 is a front structural view of an apparatus for preparing a nano coating through plasma discharge with a substrate in planetary motion (not part of the present invention).
Figure 4 is a top view of Figure 3 (not part of the present invention).
Figure 5 is a front structural view of an apparatus for preparing a nano coating through plasma discharge with a substrate in spatial reciprocating motion (not part of the present invention).
Figure 6 is a top view of Figure 5 (not part of the present invention).
Figure 7 is a front structural view of an apparatus for preparing a nano coating through plasma discharge with a substrate in planar reciprocating motion (not part of the present invention).
Figure 8 is atop view of Figure 7 (not part of the present invention).

Wherein, 1. Reaction Chamber; 2. Electrode; 3. Circling Rotating Rack; 4.Workpieces; 5. Planetary Rotating Rack; 6. Planetary Rotating Table;7. Spatial Reciprocating Motion Table; 8, Planar Reciprocating Motion Table

### DETAILED DESCRIPTION

The following figure and embodiments are provided to further illustrate the present invention, but the present invention is not limited by the embodiments.

A method for preparing a nano coating through plasma discharge with a moving substrate according to the invention is defined in the appended claims.

### Embodiment 1

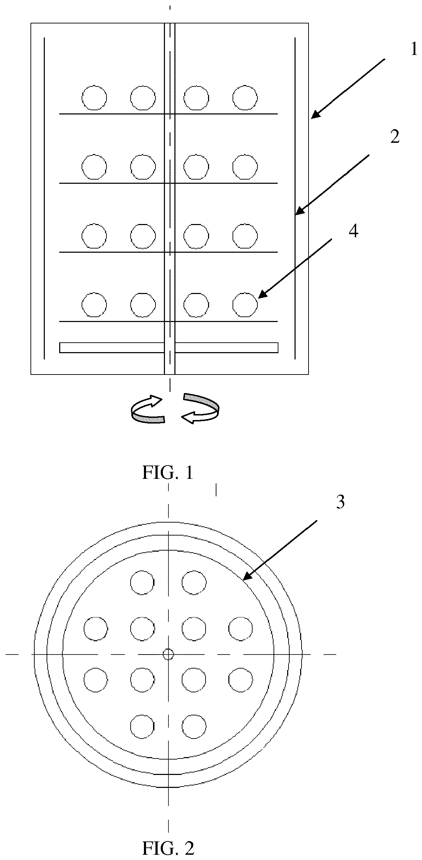

As shown in Figure1 and Figure 2, an apparatus for preparing a nano coating through plasma discharge with a moving substrate comprises a reaction chamber 1, and further comprises:
electrodes 2 configured for plasma discharge and disposed inside a space formed by the reaction chamber;
an air pumping-type vacuum exhausting device configured to form a vacuum environment, wherein the vacuum exhausting device is connected on the reaction chamber, the vacuum exhausting device includes an exhaust pipe, a first stage vacuum pump and a second stage vacuum pump, the exhaust pipe is connected to the reaction chamber, and the exhaust pipe is sequentially connected to the second stage vacuum pump and the first stage vacuum pump;
a gas pipeline used for inflows of a carrier gas and a monomer vapor;
a substrate fixing device configured for a substrate to be mounted thereon, wherein the substrate fixing device is placed inside the space formed by the electrodes;
the substrate fixing device is disposed in the space formed by the electrodes in a non-fixed manner, and the substrate is fixedly mounted on the substrate fixing device. The substrate fixing device is provided with a motion mechanism, and the substrate fixing device can move in the space formed by the electrodes as driven by the motion mechanism. The motion mode thereof is a circular motion. A circling rotating rack is disposed in a space formed by the electrodes, and a workpiece is fixed on the circling rotating rack;
the volume of the reaction chamber is 50L, and the reaction chamber is a rotary chamber.

The plasma discharge mode is continuous radio frequency discharge.

A method for preparing a nano coating through plasma discharge with a moving substrate, comprising the following steps:
(1) Put a substrate into the reaction chamber of the nano coating preparation apparatus, close the reaction chamber and vacuum the reaction chamber continuously until the vacuum degree in the reaction chamber is 10millitorr, then send in an inert gas (Ar), and turn on a movement mechanism so that the substrate can move in the reaction chamber; the substrate used in the Step (1) is a solid material, and the solid material is a block of a Teflon plate. When the substrate surface is provided with the fungus resistant nano coating, any of the surfaces can be exposed to a fungus test environment under GJB150.10A-2009.

The volume of the reaction chamber in the Step (1) is 50 L, the temperature in the reaction chamber is controlled at 30°C, and the incoming flow of the inert gas is 5sccm.

In the Step (1), the substrate moves in the reaction chamber, and the motion mode of the substrate is a circular motion relative to the reaction chamber with a speed of1 r/min.

(2) Send a monomer vapor into the reaction chamber till the vacuum degree reaches 30millitorr, enable the plasma discharge, and carry out chemical vapor deposition. The deposition process consists of pretreatment and coating phases. In the pretreatment phase, the plasma discharge power is 120 W, and the time is 900 s; subsequently in the coating phase, the plasma discharge power is10W, and the time is 7200 s; and then a fungus resistant nano coating is prepared through chemical vapor deposition on the substrate surface.

In the Step (2):
the introduction of a monomer vapor is to atomize and volatilize the monomer through the feeding pump, and to introduce the monomer to the reaction chamber by a low pressure of 10 millitorr, and the incoming flow of the monomer is 1000 µL/min;
the components of the monomer vapor are:
a mixture of two mono-functional unsaturated fluorocarbon resins and two poly-functional unsaturated hydrocarbon derivatives, wherein the mass fraction of the poly-functional unsaturated hydrocarbon derivatives in the monomer vapor is 15%;
the mono-functional unsaturated fluorocarbon resins are: 2-perfluoro octyl ethyl acrylate and 2-(perfluorohexyl) ethyl methacrylate;
the poly-functional unsaturated hydrocarbon derivatives are: diacrylicgylcol ester and 1, 6-hexanediol diacrylate;

(3) When the coating is completed, stop the introduction of the raw material monomer vapor, and in the meanwhile, stop the plasma discharge; vacuum continuously so as to keep the vacuum degree of reaction chamber at 10millitorr for 1 min, then send in the air to one barometric pressure, and take out the substrate.

The performance test results of the obtained Teflon plate deposited with the fungus resistant coating are shown as follows:

| Teflon plate - Performance test | | | | | |
|---|---|---|---|---|---|
| Thicknes s | Water contact angle | Oil contact angle | Adhesion | Fungus resistance grade | Degree of surface fungus spots |
| 356nm | 135° | 93° | Low adhesion, water droplets easily slipped | Grade 2 | 4% |
| 347nm | 133° | 98° | | Grade 2 | 4% |
| 351nm | 133° | 96° | | Grade 2 | 4% |

### Embodiment 2

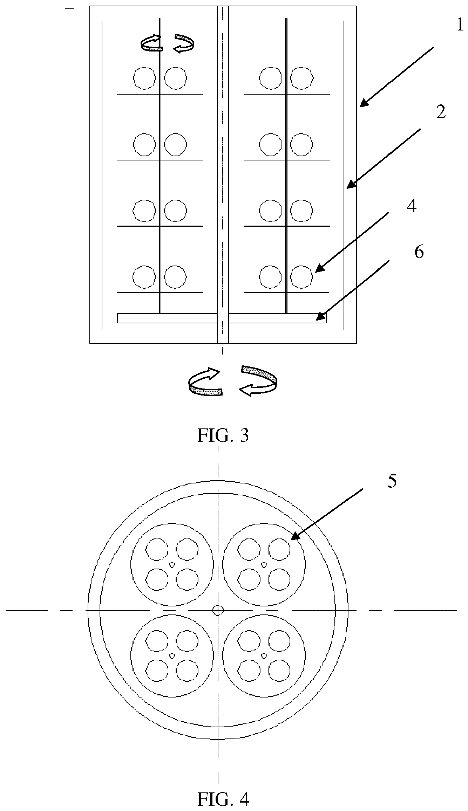

As shown in Figure 3 and Figure 4, an apparatus for preparing a nano coating through plasma discharge with a moving substrate comprises a reaction chamber 1, and further comprises:
electrodes 2 configured for plasma discharge and disposed inside a space formed by the reaction chamber;
an air pumping-type vacuum exhausting device configured-to form a vacuum environment, wherein the vacuum exhausting device is connected on the reaction chamber, the vacuum exhausting device includes an exhaust pipe, a first stage vacuum pump and a second stage vacuum pump, the exhaust pipe is connected to the reaction chamber, and the exhaust pipe is sequentially connected to the second stage vacuum pump and the first stage vacuum pump;
a gas pipeline used for inflows of a carrier gas and a monomer vapor;
a substrate fixing device configured for a substrate to be mounted thereon, wherein the substrate fixing device is placed inside the space formed by the electrodes;
the substrate fixing device is disposed in the space formed by the electrodes in a non-fixed manner, and the substrate is fixedly mounted on the substrate fixing device. The substrate fixing device is provided with a motion mechanism, and the substrate fixing device can move in the space formed by the electrodes as driven by the motion mechanism. The motion mode thereof is a planetary motion. A planetary rotating rack 5 is disposed in space formed by the electrodes, a planetary rotating table 6 is disposed on the planetary rotating rack 5, and a work piece 4 is fixed on the-planetary rotating table;
the volume of the reaction chamber is 250 L, and the reaction chamber is a rotary chamber.
The plasma discharge mode is intermediate frequency continuous discharge, and the waveform of the intermediate frequency discharge is sinusoidal.

A method for preparing a nano coating through plasma discharge with a moving substrate, comprising the following steps:
(1) Put a substrate into the reaction chamber of the nano coating-preparation apparatus, close the reaction chamber and vacuum the reaction chamber continuously until the vacuum degree in the reaction chamber is 60millitorr, then send in an inert gas (He), and turn on a movement mechanism so that the substrate can move in the reaction chamber;
   the substrate used in the Step (1) is a solid material, and the solid material is a bulk aluminum alloy-material; when the substrate surface is provided with the acidic and alkaline environment resistant coating, any of the surfaces can be exposed to acidic and alkaline test environments.

The volume of the reaction chamber in the Step (1) is 250 L, the temperature in the reaction chamber is controlled at 40°C, and the incoming flow of the inert gas is 15 sccm.

In the Step (1), the substrate carries out a planetary motion, the revolution speed is 1 r/min, and the auto rotation speed is 1.5 r/min.

(2) Send a monomer vapor into the reaction chamber till the vacuum degree reaches 90millitorr, enable the plasma discharge, and carry out chemical vapor deposition. In the pretreatment phase, the plasma discharge power is 200 W, and the time is 700 s; subsequently in the coating phase, the discharge power is30W, and the time is 600 s; and then an acidic and alkaline environment resistant nano coating is prepared through chemical vapor deposition on the substrate surface.

In the Step (2):
the introduction of a monomer vapor is to atomize and volatilize the monomer through the feeding pump, and to introduce the monomer to the reaction chamber by a low pressure of 60 millitorr, and the incoming flow of the monomer is 700 µL/min;
the components of the monomer vapor are:
a mixture of three mono-functional unsaturated fluorocarbon resins and two poly-functional unsaturated hydrocarbon derivatives, wherein the mass fraction of the poly-functional unsaturated hydrocarbon derivatives in the monomer vapor is 35%;
the mono-functional unsaturated fluorocarbon resins are: 2-(perfluorodecyl) ethyl methacrylate, 2-(perfluorododecyl) ethyl acrylate, and(perfluoro cyclohexyl) methyl acrylate;
the polyfunctional unsaturated hydrocarbon derivatives are: tripropylene glycol diacrylate and poly (ethylene glycol) diacrylate;

(3) When the coating is completed, stop the introduction of the raw material monomer vapor, and in the meanwhile, stop the plasma discharge;-vacuum continuously so as to keep the vacuum degree of reaction chamber at 80millitorr for 2 min, then send in the air to one barometric pressure, and take out the substrate.

The acidic and alkaline test results of the coated aluminum alloy materials are shown as follows:

| Material | Acid / alkali reagents | Time | | | |
|---|---|---|---|---|---|
| | | 48h | 96h | 144h | 192h |
| Aluminum alloy | Acidic salt spray | pass | pass | pass | pass |
| | Neutral salt spray | pass | pass | pass | pass |
| | Alkaline salt spray | pass | pass | pass | pass |
| | 5% Acetic acid solution | pass | pass | pass | pass |
| | 5%NaOH solution | pass | pass | pass | pass |

### Embodiment 3

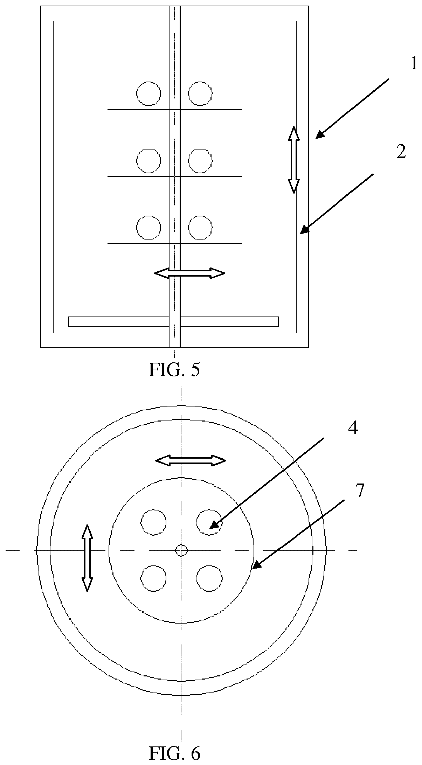

As shown in Figure 5 and Figure 6, an apparatus for preparing a nano coating through plasma discharge with a moving substrate comprises a reaction chamber 1, and further comprises:
electrodes 2 configured for plasma discharge and disposed inside a space formed by the reaction chamber;
an air pumping-type vacuum exhausting device configured to form a vacuum environment, wherein the vacuum exhausting device is connected on the reaction chamber, the vacuum exhausting device includes an exhaust pipe, a first stage vacuum pump and a second stage vacuum pump, the exhaust pipe is connected to the reaction chamber, and the exhaust pipe is sequentially connected to the second stage vacuum pump and the first stage vacuum pump;
a gas pipeline used for inflows of a carrier gas and a monomer vapor;
a substrate fixing device configured for a substrate to be mounted thereon, wherein the substrate fixing device is placed inside the space formed by the electrodes;
the substrate fixing device is disposed in the space formed by the electrodes in a non-fixed manner, and the substrate is fixedly mounted on the substrate fixing device. The substrate fixing device is provided with a motion mechanism, and the substrate fixing device can move in the space formed by the electrodes as driven by the motion mechanism. The motion mode thereof is a spatial reciprocating motion. A spatial reciprocating motion table 7 is set inside the space formed by the electrodes;

The volume of the reaction chamber is 480 L, and the reaction chamber is a cubic chamber.

The plasma discharge mode is high frequency continuous discharge, and the waveform of the high frequency discharge is bipolar pulses.

A method for preparing a nano coating through plasma discharge with a moving substrate, comprising the following steps:
(1) Put a substrate into the reaction chamber of the nano coating preparation apparatus, close the reaction chamber and vacuum the reaction chamber continuously until the vacuum degree in the reaction chamber is 130millitorr, then send in an inert gas (Ar), and turn on a movement mechanism so that the substrate can move in the reaction chamber;
   the substrate used in the Step (1) is a solid material, and the solid material is a bulk alloy steel plate. When the substrate surface is provided with a coating resistant to organic solvent immersion and cosmetics, any of the surfaces can be exposed to the organic solvent test environment.

The volume of the reaction chamber in the Step (1) is 480 L, the temperature in the reaction chamber is controlled at 50°C, and the incoming flow of the inert gas is 60sccm.

In the Step (1), the substrate carries out a spatial reciprocating motion, the up-and-down motion speed is 5 mm/min, the side-to-side motion speed is 3 mm/min, and the front-to-back motion speed is 6 mm/min.

(2) Send a monomer vapor into the reaction chamber till the vacuum degree reaches 150millitorr, enable the plasma discharge, and carry out chemical vapor deposition. In the pretreatment phase, the plasma discharge power is 250 W, and the time is 580 s; subsequently in the coating phase, the discharge power is 45 W, and the time is 4000 s; and then a nano coating resistant to organic solvent immersion and cosmetics is prepared through chemical vapor deposition on the substrate surface.

In the Step (2):
the introduction of a monomer vapor is to atomize and volatilize the monomer through the feeding pump, and to introduce the monomer to the reaction chamber by a low pressure of 10 millitorr, and the incoming flow of the monomer is 550 µL/min;
the components of the monomer vapor are:
a mixture of two mono-functional unsaturated fluorocarbon resins and two poly-functional unsaturated hydrocarbon derivatives, wherein the mass fraction of the poly-functional unsaturated hydrocarbon derivatives in the monomer vapor is 38%;
the mono-functional unsaturated fluorocarbon resins are: (perfluoro cyclohexyl) methyl acrylate and 2-(perfluorohexyl) ethyl methacrylate;
the poly-functional unsaturated hydrocarbon derivatives are: ethoxylated trimethylolpropane triacrylate, and diethylene glycol divinyl ether;

(3) When the coating is completed, stop the introduction of the raw material monomer vapor, and in the meanwhile, stop the plasma discharge; vacuum continuously so as to keep the vacuum degree of reaction chamber at 130millitorr for 3min, then send in the air to one barometric pressure, and take out the substrate.

After the above alloy steel plate is coated, the organic solvent resistance test results are shown as follows:

| Material of substrate | Chemical reagents | | Time | | | |
|---|---|---|---|---|---|---|
| | | 48h | | 96h | 144h | 192h |
| Alloy steel plate | Acetone | pass | | pass | pass | pass |
| | Cyclohexane | pass | | pass | pass | pass |
| | Petroleum ether | pass | | pass | pass | pass |
| | Xylene | pass | | pass | pass | pass |
| | 1-Propanol | pass | | pass | pass | pass |

### Embodiment 4

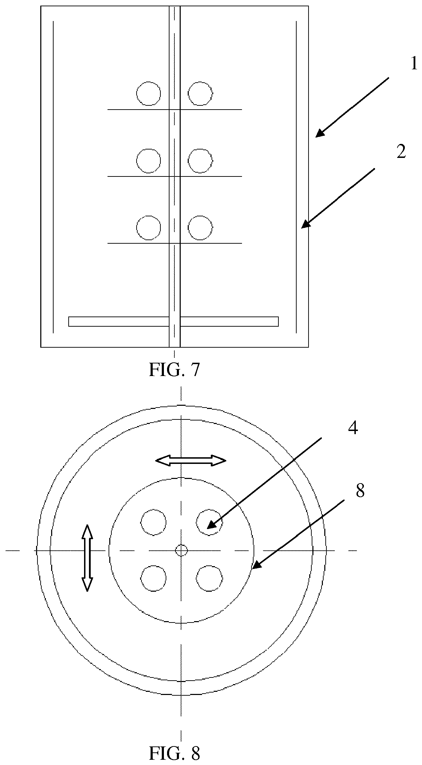

As shown in Figure 7 and Figure 8, an apparatus for preparing a nano coating through plasma discharge with a moving substrate comprises a reaction chamber 1, and further comprises:
electrodes 2 configured for plasma discharge and disposed inside a space formed by the reaction chamber;
an air pumping-type vacuum exhausting device configured to form a vacuum environment, wherein the vacuum exhausting device is connected on the reaction chamber, the vacuum exhausting device includes an exhaust pipe, a first stage vacuum pump and a second stage vacuum pump, the exhaust pipe is connected to the reaction chamber, and the exhaust pipe is sequentially connected to the second stage vacuum pump and the first stage vacuum pump;
a gas pipeline used for inflows of a carrier gas and a monomer vapor;
a substrate fixing device configured for a substrate to be mounted thereon, wherein the substrate fixing device is placed inside the space formed by the electrodes;
the substrate fixing device is disposed in the space formed by the electrodes in a non-fixed manner, and the substrate is fixedly mounted on the substrate fixing device. The substrate fixing device is provided with a motion mechanism, and the substrate fixing device can move in the space formed by the electrodes as driven by the motion mechanism. The motion mode thereof is a planar reciprocating motion. Aplanar reciprocating motion table 7 is set inside the space formed by the electrodes;

The volume of the reaction chamber is 680L, and the reaction chamber is a cubic chamber.

The plasma discharge mode is microwave continuous discharge.

A method for preparing a nanocoating through plasma discharge with a moving substrate, comprising the following steps:
(1) Put a substrate into the reaction chamber of the nano coating preparation apparatus, close the reaction chamber and vacuum the reaction chamber continuously until the vacuum degree in the reaction chamber is 160millitorr, then send in an inert gas (He), and turn on a movement mechanism so that the substrate can move in the reaction chamber;
   the substrate used in the Step (1) is a solid material, and the solid material is a bulk aluminum material and a PCB board. When the substrate surface is provided with a coating resistant to thermal cycling impact, any of the surfaces can be exposed to the thermal cycling test environment.

The volume of the reaction chamber in the Step (1) is 680 L, the temperature in the reaction chamber is controlled at 50°C, and the incoming flow of the inert gas is 160sccm.

In the Step (1), the substrate carries out a planar reciprocating motion, the side-to-side motion speed is 6 mm/min, and the front-to-back motion speed is 9 mm/min.

(2) Send a monomer vapor into the reaction chamber till the vacuum degree reaches 190millitorr, enable the plasma discharge, and carry out chemical vapor deposition. In the pretreatment phase, the plasma discharge power is 300 W, and the time is 350 s; subsequently in the coating phase, the discharge power is 55 W, and the time is 2200 s; and then a nano coating resistant to resistant to thermal cycling impact is prepared through chemical vapor deposition on the substrate surface.

In the Step (2):
the introduction of a monomer vapor is to atomize and volatilize the monomer through the feeding pump, and to introduce the monomer to the reaction chamber by a low pressure of 160 millitorr, and the incoming flow of the monomer is 220 µL/min;
the components of the monomer vapor are:
a mixture of three mono-functional unsaturated fluorocarbon resins and three poly-functional unsaturated hydrocarbon derivatives, wherein the mass fraction of the poly-functional unsaturated hydrocarbon derivatives in the monomer vapor is 52%;
the mono-functional unsaturated fluorocarbon resins are: 3, 3, 3-trifluoro-1-propyne, 3-(perfluoro-5-methyl hexyl)-2-hydroxypropyl methacrylate, and 1H, 1H, 2H, 2H- perfluoro octanol acrylate;
the poly-functional unsaturated hydrocarbon derivatives are: ethoxylated trimethylolpropane triacrylate, diacrylicgylcol ester, and 1, 6-hexanediol diacrylate;

(3) When the coating is completed, stop the introduction of the raw material monomer vapor, and in the meanwhile, stop the plasma discharge; vacuum continuously so as to keep the vacuum degree of reaction chamber at 160millitorr for 4min, then send in the air to one barometric pressure, and take out the substrate.

After the above bulk aluminum material and PCB board are coated, the thermal cycling impact test results are shown as follows:

| Substrate to be tested | Test condition | Number of cycles | Test time | Result detection |
|---|---|---|---|---|
| Aluminum substrate | -40°C-+75°C | 25 | 2h | No effect on appearance Good performance |
| PCB board | -40°C-+75°C | 25 | 2h | No effect on appearance Good performance |

### Embodiment 5

As shown in Figure1 and Figure 2, an apparatus for preparing a nano coating through plasma discharge with a moving substrate comprises a reaction chamber 1, and further comprises:
electrodes 2 configured for plasma discharge and disposed inside a space formed by the reaction chamber;
an air pumping-type vacuum exhausting device configured to form a vacuum environment, wherein the vacuum exhausting device is connected on the reaction chamber, the vacuum exhausting device includes an exhaust pipe, a first stage vacuum pump and a second stage vacuum pump, the exhaust pipe is connected to the reaction chamber, and the exhaust pipe is sequentially connected to the second stage vacuum pump and the first stage vacuum pump;
a gas pipeline used for inflows of a carrier gas and a monomer vapor;
a substrate fixing device configured for a substrate to be mounted thereon, wherein the substrate fixing device is placed inside the space formed by the electrodes;
the substrate fixing device is disposed in the space formed by the electrodes in a non-fixed manner, and the substrate is fixedly mounted on the substrate fixing device. The substrate fixing device is provided with a motion mechanism, and the substrate fixing device can move in the space formed by the electrodes as driven by the motion mechanism. The motion mode thereof is a circular motion. A circling rotating rack is disposed in a space formed by the electrodes, and a workpiece is fixed on the circling rotating rack;
the volume of the reaction chamber is 580 L, and the reaction chamber is a rotary chamber.

The plasma discharge mode is continuous radio frequency discharge.

A method for preparing a nano coating through plasma discharge with a moving substrate, comprising the following steps:
(1) Put a substrate into the reaction chamber of the nano coating preparation apparatus, close the reaction chamber and vacuumize the reaction chamber continuously until the vacuum degree in the reaction chamber is 200millitorr, then send in an inert gas (Ar), and turn on a movement mechanism so that the substrate can move in the reaction chamber;
   the substrate used in the Step (1) is a solid material, and the solid material is an electronic component; when the substrate surface is provided with a coating resistant to alternating dampness and heat, any of the surfaces can be exposed to the dampness and heat test environment.

The volume of the reaction chamber in the Step (1) is 1000 L, the temperature in the reaction chamber is controlled at 60°C, and the incoming flow of the inert gas is 300sccm.

In the Step (1), the substrate moves in the reaction chamber, and the motion mode of the substrate is a circular motion relative to the reaction chamber with a speed of 1 r/min.

(2) Send a monomer vapor into the reaction chamber till the vacuum degree reaches 300 millitorr, enable the plasma discharge, and carry out chemical vapor deposition. In the pretreatment phase, the plasma discharge power is 400 W, and the time is 60 s; subsequently in the coating phase, the discharge power is 75 W, and the time is 600 s; and then a nano coating resistant to alternating dampness and heat is prepared through chemical vapor deposition on the substrate surface.

In the Step (2):
the introduction of a monomer vapor is to atomize and volatilize the monomer through the feeding pump, and to introduce the monomer to the reaction chamber by a low pressure of 200 millitorr, and the incoming flow of the monomer is 10 µL/min;
the components of the monomer vapor are:
a mixture of three mono-functional unsaturated fluorocarbon resins and two poly-functional unsaturated hydrocarbon derivatives, wherein the mass fraction of the poly-functional unsaturated hydrocarbon derivatives in the monomer vapor is 65%;
the mono-functional unsaturated fluorocarbon resins are: 1H, 1H, 2H, 2H- perfluoro octanol acrylate, 3, 3, 3-trifluoro-1-propyne, and 2-(perfluorohexyl) ethyl methacrylate;
the poly-functional unsaturated hydrocarbon derivatives are: tripropylene glycol diacrylate and diacrylicgylcol ester;
in the Step (2), the plasma discharge mode is spark discharge.

(3) When the coating is completed, stop the introduction of the raw material monomer vapor, and in the meanwhile, stop the plasma discharge; vacuumize continuously so as to keep the vacuum degree of reaction chamber at 200millitorr for 5 min, then send in the air to one barometric pressure, and take out the substrate.

The alternating dampness and heat test results of the above coated electronic component are shown as follows:

| Substrate to be tested | | Test conditions and results | | | | | | | |
|---|---|---|---|---|---|---|---|---|---|
| Electronic component | | Temperature | | | 25°C | | | | |
| | Humidity | | | 75 | | 80 | 85 | 90 | 95 |
| | Time | | 12h | Pass | | Pass | Pass | Pass | Pass |
| | Time | | 24h | Pass | | Pass | Pass | Pass | Pass |
| | Time | | 36h | Pass | | Pass | Pass | Pass | Pass |
| | Time | | 48h | Pass | | Pass | Pass | Pass | Pass |

## Claims

1. A method for preparing a nano coating through plasma discharge with a moving substrate, wherein the method consists of the following steps:
(1) putting a substrate into the reaction chamber of a nano coating preparation apparatus, vacuumizing the reaction chamber continuously until the vacuum degree in the reaction chamber is in a range of 10-200 millitorr, sending in an inert gas (He or Ar), and turning on the movement mechanism to allow the substrate to move in the reaction chamber;
(2) sending a monomer vapor into the reaction chamber till the vacuum degree reaches 30-300 millitorr, enabling the plasma discharge, and carrying out chemical vapor deposition consisting of pretreatment and coating phases, wherein in the pretreatment phase, plasma discharge power is 120-400 W, and continuous discharge time is 60-900 s; subsequently in the coating phase, the plasma discharge power is adjusted to 10-75 W, the continuous discharge time is adjusted to 600 s-7200 s, and a multi-functional nano coating is prepared through the chemical vapor deposition on a substrate surface;
wherein components of the monomer vapor are:
a mixture of at least one monofunctional unsaturated fluorocarbon resin and at least one polyfunctional unsaturated hydrocarbon derivative, wherein a mass fraction of the polyfunctional unsaturated hydrocarbon derivative in the monomer vapor is 15-65%,
the mono-functional unsaturated fluorocarbon resin consists of:
3-(perfluoro-5-methyl hexyl)-2-hydroxypropyl methacrylate, 2-(perfluorodecyl) ethyl methacrylate, 2-(perfluorohexyl) ethyl methacrylate, 2-(perfluorododecyl) ethyl acrylate, 2-perfluoro octyl ethyl acrylate, IH, IH, 2H, 2H- perfluoro octanol acrylate, 2-(perfluorobutyl) ethyl acrylate, (2H-perfluoro propyl)-2-acrylate, (perfluoro cyclohexyl) methyl acrylate, 3, 3, 3-trifluoro-1-propyne, 1-ethinyl-3, 5-difluorobenzene or 4-ethinyl trifluorotoluene;
the polyfunctional unsaturated hydrocarbon derivative consists of:
ethoxylated trimethylolpropane triacrylate, tripropylene glycol diacrylate, poly (ethylene glycol) diacrylate, 1, 6-hexanediol diacrylate, diacrylicgylcol ester, diethylene glycol divinyl ether, or neopentyl glycol diacrylate;
(3) stopping supplying the monomer vapor, and in the meanwhile, stopping the plasma discharge, vacuumizing continuously, sending in the air to one barometric pressure after keeping the vacuum degree of the reaction chamber in a range of 10-200 millitorr for 1-5 min, stopping a movement of the substrate, and taking out the substrate.

2. The method for preparing the nano coating through the plasma discharge with the moving substrate according to claim 1, **characterized in that** the substrate in the Step (1) is a solid material, and the solid material can be electronic products, electrical components, assembled electronic semi-finished products, PCB boards, metal plates, Teflon plates or electronic parts and components, and when the substrate surface is provided with the nano coating, any of the surfaces is used in exposure to an environment of water, fungi, acidicor alkaline solvents, acidicor alkaline salt spray, acidic atmosphere, organic solvent immersion, cosmetics, perspiration, thermal cycling impact or alternating dampness and heat.

3. The method for preparing the nano coating through the plasma discharge with the moving substrate according to claim 1, **characterized in that** in the Step (1), a temperature of the reaction chamber is controlled within a range of 30-60°(, and an incoming flow of the inert gas is 5-300 seem.

4. The method for preparing the nano coating through the plasma discharge with the moving substrate according to claim 1, **characterized in that** the Step (2) of sending the monomer vapor includes atomizing and volatilizing a monomer through a feeding pump, and introducing the monomer to the reaction chamber by a low pressure of 10-200 millitorr, wherein an incoming flow of the monomer is 10-1000 µL/min;

## Patentansprüche

1. Verfahren zum Herstellen einer Nanobeschichtung durch Plasmaentladung mit einem sich bewegenden Substrat, wobei das Verfahren die folgenden Schritte umfasst:
(1) Setzen eines Substrats in die Reaktionskammer einer Nanobeschichtungsvorrichtung, durchgängiges Evakuieren der Reaktionskammer, bis ein Vakuumgrad in der Reaktionskammer in einem Bereich von 10 bis 200 mTorr ist, Einleiten eines Edelgases (He oder Ar), und Einschalten eines Fördermechanismus, um dem Substrat zu ermöglichen, sich in der Reaktionskammer zu bewegen;
(2) Einleiten eines Monomerdampfes in die Reaktionskammer, bis der Vakuumgrad 30 bis 300 mTorr erreicht, Aktivieren der Plasmaentladung, und Ausführen einer chemischen Dampfabscheidung, die eine Vorbehandlungs- und eine Beschichtungsphase umfasst, wobei in der Vorbehandlungsphase eine Plasmaentladeleistung 120 bis 400 W beträgt und eine Dauer der durchgängigen Entladung 60 bis 900 s beträgt; anschließend in der Beschichtungsphase die Plasmaentladeleistung auf 10 bis 75 W angepasst wird und die Dauer der durchgängigen Entladung auf 600 s bis 7200 s angepasst wird, und durch die chemische Dampfabscheidung auf einer Substratoberfläche eine multifunktionale Nanobeschichtung hergestellt wird;
wobei Komponenten des Monomerdampfes sind:
eine Mischung aus mindestens einem monofunktionalen ungesättigten Fluorcarbonkunststoff und mindesten einem polyfunktionalen ungesättigten Kohlenwasserstoffderivat, wobei ein Masseanteil des polyfunktionalen ungesättigten Kohlenwasserstoffderivats in dem Monomerdampf 15 bis 65 % beträgt,
der monofunktionale ungesättigte Fluorcarbonkunststoff besteht aus:
3-(Perfluor-5-methylhexyl)-2-hydroxypropylmethacrylat, 2-(Perfluordodecyl)-Ethylmethacrylat, 2-(Perfluorhexyl)-Ethylmethacrylat, 2-(Perfluordodecyl)-Ethylacrylat, 2-Perfluoroctylethylacrylat, IH, IH, 2H, 2H-Perfluoro-Octanol-Acrylat, 2-(Perfluorobutyl)-EthylAcrylat, (2H-Perfluoro-Propyl)-2-Acrylat, (Perfluoro-Cyclohexyl)-Methylacrylat, 3,3,3-Trifluoro-1-Propin, 1-Ethinyl-3,5-Difluorobenzen oder 4-Ethinyl-Trifluorotoluen;
und das polyfunktionale ungesättigte Kohlenwasserstoffderivat besteht aus:
ethoxyliertem Trimethylolpropantriacrylat, Tripropylenglykoldiacrylat, Poly(ethylenglykol)diacrylat, 1,6-Hexandioldiacrylat, Diacrylglykolester, Diethylenglykoldivinylether oder Neopentylglykoldiacrylat;
(3) Stoppen der Zufuhr des Monomerdampfes, und unterdessen Stoppen der Plasmaentladung, durchgängiges Evakuieren, Einleiten von Luft bis auf einen Atmosphärendruck, nachdem der Vakuumgrad der Reaktionskammer für 1 bis 5 min in einem Bereich von 10 bis 200 mTorr gehalten wurde, Stoppen einer Bewegung des Substrats, und Herausnehmen des Substrats.

2. Verfahren zum Herstellen der Nanobeschichtung durch die Plasmaentladung mit dem sich bewegenden Substrat nach Anspruch 1, **dadurch gekennzeichnet, dass** das Substrat in Schritt (1) ein festes Material ist, und es sich bei dem festen Material um elektronische Produkte, elektrische Komponenten, montierte elektronische Halbzeuge, Leiterplatten, Metallplatten, Teflonplatten oder elektronische Teile und Komponenten handeln kann, und wenn die Substratoberfläche mit der Nanobeschichtung versehen ist, eine der Oberflächen in Benutzung einer Umgebung mit Wasser, Pilzen, sauren oder alkalischen Lösungsmitteln, saurem oder alkalischem Salzsprühnebel, saurem Medium, Immersion in organische Lösungsmittel, Kosmetika, Schweiß, thermischer Wechselbeanspruchung oder abwechselnder Feuchtigkeit und Hitze ausgesetzt wird.

3. Verfahren zum Herstellen der Nanobeschichtung durch die Plasmaentladung mit dem sich bewegenden Substrat nach Anspruch 1, **dadurch gekennzeichnet, dass** in Schritt (1) eine Temperatur der Reaktionskammer innerhalb eines Bereichs von 30 bis 60 °C geregelt wird und ein Zustrom des Edelgases 5 bis 300 sccm beträgt.

4. Verfahren zum Herstellen der Nanobeschichtung durch die Plasmaentladung mit dem sich bewegenden Substrat nach Anspruch 1, **dadurch gekennzeichnet, dass** der Schritt (2) des Einleitens des Monomerdampfs umfasst: Atomisieren und Verflüchtigen eines Monomers durch eine Beschickungspumpe, und Einbringen des Monomers in die Reaktionskammer durch einen Unterdruck von 10 bis 200 mTorr, wobei ein Zustrom des Monomers 10 bis 1000 µL/min beträgt.

## Revendications

1. Procédé de préparation d'un nano-revêtement au moyen d'une décharge de plasma avec un substrat en déplacement, dans lequel le procédé est constituée des étapes suivantes :
(1) mise d'un substrat dans la chambre de réaction d'un appareil de préparation de nano-revêtement, mise sous vide de la chambre de réaction en continu jusqu'à ce que le degré de vide dans la chambre de réaction soit dans une plage de 10 à 200 millitorr, l'introduction d'un gaz inerte (He ou Ar), et la mise en marche du mécanisme de déplacement pour permettre au substrat de se déplacer dans la chambre de réaction ;
(2) l'envoi d'une vapeur d'un monomère dans la chambre de réaction jusqu'à ce que le degré de vide atteigne 30 à 300 millitorr, permettant la décharge de plasma, et réalisant un dépôt chimique en phase vapeur constitué de phases de prétraitement et de revêtement, dans lequel, lors de la phase de prétraitement, la puissance de décharge de plasma est de 120 à 400 W, et le temps de décharge en continu est de 60 à 900 s ; par la suite lors de la phase de revêtement, la puissance de décharge de plasma est réglée sur 10 à 75 W, le temps de décharge en continue est réglé sur 600 s à 7200 s, et un nano-revêtement multifonctionnel est préparé par dépôt chimique en phase vapeur sur une surface de substrat ;
dans lequel les composants de la vapeur de monomère sont :
un mélange d'au moins une résine fluorocarbonée insaturée monofonctionnelle et d'au moins un dérivé d'hydrocarbure insaturé polyfonctionnel, dans lequel une fraction massique du dérivé d'hydrocarbure insaturé polyfonctionnel dans la vapeur de monomère est de 15 à 65 %,
la résine fluorocarbonée insaturée monofonctionnelle est constituée :
de méthacrylate de 3-(perfluoro-5-méthyl hexyl)-2-hydroxypropyle, de méthacrylate de 2-(perfluorodécyl) éthyle, de méthacrylate de 2-(perfluorohexyl) éthyle, d'acrylate de 2-(perfluorododécyl) éthyle, d'acrylate de 2-perfluoro octyl éthyle, d'acrylate de 1H,1H,2H,2H-perfluoro octanol, d'acrylate de 2-(perfluorobutyl) éthyle, de (2H-perfluoro propyl)-2-acrylate, d'acrylate de (perfluoro cyclohexyl) méthyle, du 3,3,3-trifluoro-1-propyne, de 1-éthinyl-3,5-difluorobenzène ou de 4-éthinyl trifluorotoluène ;
le dérivé d'hydrocarbure insaturé polyfonctionnel est constitué :
de triacrylate de triméthylolpropane éthoxylé, de diacrylate de tripropylène glycol, de diacrylate de poly (éthylène glycol), de diacrylate de 1,6-hexanediol, d'ester diacrylique de gylcol, d'éther divinylique de diéthylène glycol, ou de diacrylate de néopentyl glycol ;
(3) l'arrêt de la fourniture de la vapeur de monomère, et dans le même temps, l'arrêt de la décharge de plasma, la mise sous vide en continu, l'introduction d'air à une pression barométrique après le maintien du degré de vide de la chambre de réaction dans une plage de 10 à 200 millitorrs pendant 1 à 5 min, l'arrêt d'un déplacement du substrat, et le retrait du substrat.

2. Procédé de préparation du nano-revêtement au moyen de la décharge de plasma avec le substrat en déplacement selon la revendication 1, **caractérisé en ce que** le substrat à l'étape (1) est un matériau solide, et le matériau solide peut être des produits électroniques, des composants électriques, des produits semi-finis électroniques assemblés, des cartes de circuit imprimé, des plaques métalliques, des plaques en téflon ou des pièces et des composants électroniques, et lorsque la surface de substrat est pourvue du nano-revêtement, l'une quelconque des surfaces est utilisée en exposition à un environnement aqueux, à des champignons, à des solvants alcalins acides, à une pulvérisation de sel alcalin acide, à une atmosphère acide, à une immersion dans un solvant organique, à des cosmétiques, à de la transpiration, à l'impact d'un cycle thermique ou à une alternance d'humidité et de chaleur.

3. Procédé de préparation du nano-revêtement au moyen de la décharge de plasma avec le substrat en déplacement selon la revendication 1, **caractérisé en ce qu'**à l'étape (1), une température de la chambre de réaction est régulée dans une plage de 30 à 60 °C, et un écoulement entrant du gaz inerte est de 5 à 300 cm³/min.

4. Procédé de préparation du nano-revêtement au moyen de la décharge de plasma avec le substrat en déplacement selon la revendication 1, **caractérisé en ce que** l'étape (2) d'envoi de la vapeur de monomère comporte l'atomisation et la volatilisation d'un monomère au moyen d'une pompe d'alimentation, et l'introduction du monomère dans la chambre de réaction à une basse pression de 10 à 200 millitorr, dans lequel un écoulement entrant du monomère est de 10 à 1000 µL/min ;
